# EUROPEAN PATENT SPECIFICATION

(11) **EP 3 684 157 B1**
(45) Date of publication and mention of the grant of the patent: **19.06.2024**
(21) Application number: 17924906.5
(22) Date of filing: 15.09.2017
(51) Int. Cl.: H05K 13/04, H05K 13/08

(54) **MOUNTING SYSTEM**
MONTAGESYSTEM
SYSTÈME DE MONTAGE

(43) Date of publication of application: 22.07.2020
(73) Proprietor: Fuji Corporation, Chiryu-shi, Aichi 472-8686 (JP)
(72) Inventor: HARA, Kenji, Chiryu-shi Aichi 472-8686 (JP)
(74) Representative: Grünecker Patent- und Rechtsanwälte PartG mbB
(86) International application number: PCT/JP2017/033579
(87) International publication number: WO 2019/053897

(56) References cited:
- EP-A1- 0 138 863
- EP-B1- 0 138 863
- JP-A- 2006 135 158
- JP-A- 2006 135 158
- JP-A- 2010 123 906
- JP-A- 2016 042 524
- US-A1- 2016 091 869

## Description

### Technical Field

The techniques disclosed herein relate to a mounting system.

### Background Art

Patent Literature 1 discloses a component mounting device for mounting a component on a surface of a board. The component mounting device of Patent Literature 1 includes an imaging device, configured to image a surface of a board, and a control device. The control device determines the position at which the component is mounted based on the image captured by the imaging device. Patent Literature 2 teaches to calculate the coordinates of a recognition mark on a board when those are missing from numerical control data by taking an image of the board, determining the difference amount between the coordinates of a mounting position for an arbitrary component obtained from the image of the board and the coordinates of the same mounting position in the numerical control data, and correcting coordinates of the recognition mark obtained from the image of the board by the same difference amount. Patent Literature 3 discloses a method for correcting a positioning error of a component insertion device by taking an image with an image sensor attached to the component insertion device and to compare the image with a master image of the board layout stored in memory.

### Patent Literature

Patent Literature 1: JP 2003 069288 A
Patent Literature 2: JP 2006 135158 A
Patent Literature 3: EP 0 138 863 A1

### Summary of the Invention

### Technical Problem

When a component is mounted on the surface of the board by the component mounting device, CAD data may be generated in advance in order to recognize the position where the component is mounted. The CAD data indicates the position at which the component is to be mounted on the surface of the board. The operator using the component mounting device can recognize the position where the component is to be mounted on the surface of the board by checking the CAD data. However, when the component is actually mounted on the surface of the board by the component mounting device, the actual position where the component is to be mounted on the board and the mounting position of the component indicated by the CAD data may be deviated from each other due to some cause. That is, although the actual position where the component is to be mounted on the board and the mounting position of the component indicated by the CAD data are supposed to match with each other, a positional deviation may occur between them. For example, a positional deviation may occur between the actual board and CAD data due to a discrepancy between the design drawing and the actual board in the board manufacturing process or the like. In such a case, the operator using the component mounting device can check whether a positional deviation has occurred between the actual board and the CAD data, but time is required for such a confirmation operation. In addition, if a positional deviation has occurred, there is a possibility that the component cannot be mounted at the correct position on the board surface. Therefore, the present specification provides a technique capable of easily determining whether a component can be mounted at the correct position.

### Solution to Problem

The mounting system defined by the appended set of claims provides a solution for said problem.

### Brief Description of Drawings

[Fig. 1] A block diagram of a mounting system of an embodiment.
[Fig. 2] A side view schematically showing a configuration of the mounting system of the embodiment.
[Fig. 3] A side view of a circuit board and an electronic component of the embodiment.
[Fig. 4] A top view of the circuit board of the embodiment.
[Fig. 5] A flowchart of a position comparison process executed in the mounting system of the embodiment.
[Fig. 6] An enlarged view of main part VI of Fig. 4.
[Fig. 7] A top view of a circuit board of another embodiment.

### Description of Embodiments

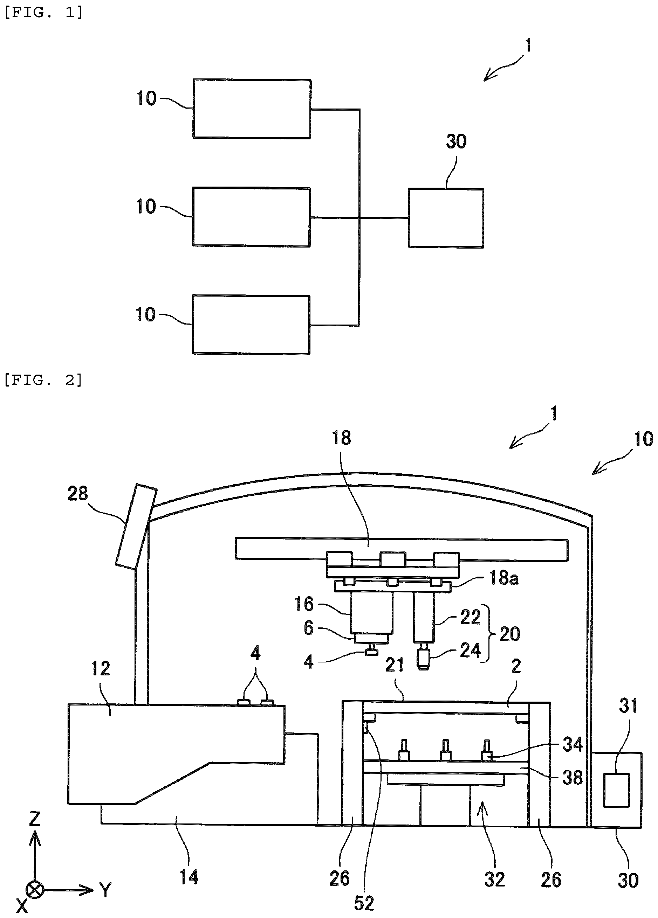

Mounting system 1 of an embodiment will be described with reference to the drawings. As shown in Fig. 1, mounting system 1 of the embodiment includes multiple component mounting devices 10 and control device 30.

First, component mounting device 10 will be described. In the following, one representative component mounting device 10 among the multiple component mounting devices 10 will be described. Component mounting device 10 is a device for mounting multiple electronic components on a circuit board. Component mounting device 10 is also referred to as a surface mounting device or a chip mounter. Normally, component mounting device 10 is provided together with a solder printing device, another component mounting device, and a board inspection device, and constitutes a series of mounting line.

As shown in Fig. 2, component mounting device 10 includes multiple component feeders 12 (one representative component feeder 12 is shown in Fig. 2), feeder holding section 14, mounting head 16, imaging unit 20, moving mechanism 18 for moving mounting head 16 and imaging unit 20, conveyance device 26, and operation panel 28.

Each component feeder 12 accommodates multiple electronic components 4. Each component feeder 12 is a device for supplying multiple electronic components 4 to be mounted on circuit board 2. Each component feeder 12 is attached to feeder holding section 14 in an exchangeable manner and supplies electronic components 4 to mounting head 16. Each component feeder 12 is, for example, a tape-type feeder that accommodates multiple electronic components 4 in a wound-tape format. Each component feeder 12 supplies electronic components 4 by feeding out a tape in which multiple electronic components 4 are arranged in a line. The specific configuration of component feeder 12 is not particularly limited. Each component feeder 12 may be a tray-type feeder that accommodates multiple electronic components 4 on a tray or a bulk-type feeder that randomly accommodates multiple electronic components 4 in a container.

Moving mechanism 18 moves mounting head 16 and imaging unit 20 between component feeder 12 and circuit board 2. Moving mechanism 18 of the present embodiment is an XY robot that moves movement base 18a in the X-direction and the Y-direction. Moving mechanism 18 includes guide rails for guiding movement base 18a, a moving mechanism for moving movement base 18a along the guide rails, a motor for driving the moving mechanism, and the like. Moving mechanism 18 is disposed above component feeder 12 and circuit board 2. Mounting head 16 and imaging unit 20 are attached to movement base 18a. Mounting head 16 and imaging unit 20 are moved above component feeder 12 and above circuit board 2 by moving mechanism 18.

Mounting head 16 includes suction nozzle 6 that picks up electronic components 4. Suction nozzle 6 is detachable from mounting head 16. Suction nozzle 6 is attached to mounting head 16 so as to be movable in the Z-direction. Suction nozzle 6 is configured to move up and down in the up-down direction and pick up electronic components 4 by suction, suction nozzle 6 being moved up and down by an actuator (not shown) accommodated in mounting head 16. In order to mount electronic component 4 on circuit board 2 by mounting head 16, first, mounting head 16 is moved to a component suction position by moving mechanism 18. Next, suction nozzle 6 is moved downward until the lower surface of suction nozzle 6 comes into contact with electronic component 4 accommodated in component feeder 12. Next, electronic component 4 is picked up by suction nozzle 6, and suction nozzle 6 is then moved upward. Next, mounting head 16 is moved to a component mounting position by moving mechanism 18 and is positioned with respect to circuit board 2. Next, by lowering suction nozzle 6 toward circuit board 2, electronic component 4 is mounted on circuit board 2.

Imaging unit 20 is attached to movement base 18a. Therefore, when mounting head 16 moves, imaging unit 20 also moves integrally. Imaging unit 20 includes camera support 22 and camera 24 (an example of an imaging device). Camera support 22 is attached to movement base 18a. Camera 24 is attached to camera support 22.

Camera 24 is a device for imaging surface 21 of circuit board 2. When imaging unit 20 is moved by moving mechanism 18 to a position above circuit board 2, camera 24 is disposed above circuit board 2. Camera 24 images surface 21 of circuit board 2 from above circuit board 2 in a state in which the entire surface 21 of circuit board 2 falls within an imaging range. Image data of surface 21 of circuit board 2 imaged by camera 24 is transmitted to control device 30. Camera 24 includes a camera control device (not shown) for controlling the operation of camera 24. The operation of camera 24 is controlled by the camera control device.

Conveyance device 26 is a device for conveying circuit board 2 into component mounting device 10, conveying and positioning circuit board 2 to the component mounting position, and conveying circuit board 2 out of component mounting device 10. Conveyance device 26 of the present embodiment can be configured by, for example, a pair of belt conveyors, supporting device 32 attached to the belt conveyors and supporting circuit board 2 from below, and a driving device for driving the belt conveyors. Circuit board 2 is conveyed in the X-direction shown in the drawing.

Supporting device 32 includes support table 38 and multiple support pins 34. Support table 38 and multiple support pins 34 are disposed below circuit board 2. Support table 38 is configured to be movable in the up-down direction. Multiple support pins 34 are fixed to support table 38 and protrude upward. In supporting device 32, when circuit board 2 is conveyed to a predetermined work position by the belt conveyors, support table 38 disposed below circuit board 2 rises. As support table 38 rises, the multiple support pins 34 fixed to support table 38 lift circuit board 2 upward.

Operation panel 28 is an input device for receiving instructions from an operator. Various information is displayed on operation panel 28.

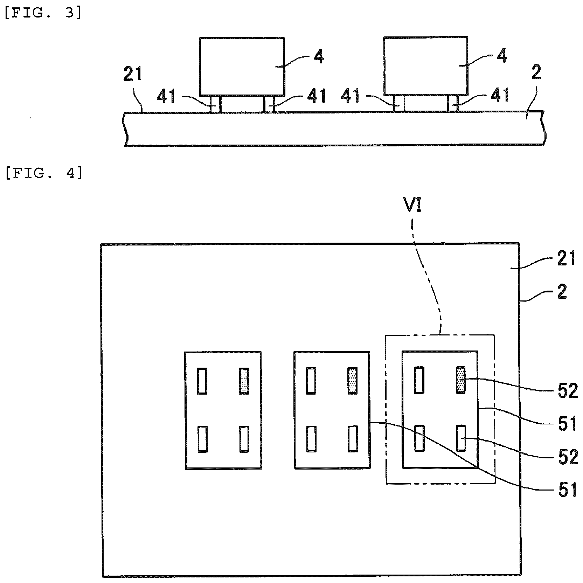

Component mounting device 10 mounts multiple electronic components 4 on circuit board 2. As shown in Fig. 3, multiple electronic components 4 are mounted on surface 21 of circuit board 2. Each electronic component 4 includes multiple electrodes 41. When electronic component 4 is mounted on surface 21 of circuit board 2, multiple electrodes 41 of electronic component 4 are fixed to surface 21 of circuit board 2. Multiple electrodes 41 are made of metal and are electrically conductive.

As shown in Fig. 4, circuit board 2 on which multiple electronic components 4 are to be mounted includes multiple planned mounting sections 51 and multiple planned electrode sections 52. Multiple planned mounting sections 51 and multiple planned electrode sections 52 are formed on surface 21 of circuit board 2. Multiple planned mounting sections 51 and multiple planned electrode sections 52 are composed of multiple wires or the like printed on surface 21 of circuit board 2. Planned mounting sections 51 are target locations where mounting of electronic components 4 are to be mounted on surface 21 of circuit board 2. Planned electrode sections 52 are target locations where electrodes 41 of electronic components 4 are to be disposed on surface 21 of circuit board 2. Multiple planned electrode sections 52 are formed within planned mounting sections 51. When each of planned mounting sections 51 of surface 21 of circuit board 2 is at predetermined position, component mounting device 10 mounts electronic component 4 on each planned mounting section 51.

Control device 30 of mounting system 1 shown in Fig. 2 includes a computer having a CPU, ROM, and RAM. Although not shown, component feeder 12, mounting head 16, moving mechanism 18, and operation panel 28 are communicably connected to control device 30. Control device 30 controls mounting of electronic components 4 on circuit board 2 by controlling these devices (12, 16, 18, 28, 32, etc). The control process by control device 30 will be described later.

Control device 30 includes memory section 31. Memory section 31 stores CAD data (an example of drawing information). The CAD data is drawing information in which surface 21 of circuit board 2 are drawn. The CAD data includes position information indicating the positions of multiple planned mounting sections 51 on surface 21 of circuit board 2. The CAD data includes position information indicating the positions of multiple planned electrode sections 52 on surface 21 of circuit board 2. In addition, control device 30 can generate a job file (an example of component mounting information) based on the CAD data. The job file is information used for mounting multiple electronic components 4 on surface 21 of circuit board 2.

Next, the operation of mounting system 1 will be described. In mounting system 1, first, moving mechanism 18 moves imaging unit 20 above circuit board 2 by moving imaging unit 20 in the X-direction and the Y-direction. As a result, camera 24 of imaging unit 20 is positioned above circuit board 2. Subsequently, camera 24 of imaging unit 20 images surface 21 of circuit board 2 in a state in which entire surface 21 of circuit board 2 falls within the imaging range. Image data of an image captured by camera 24 is transmitted to control device 30.

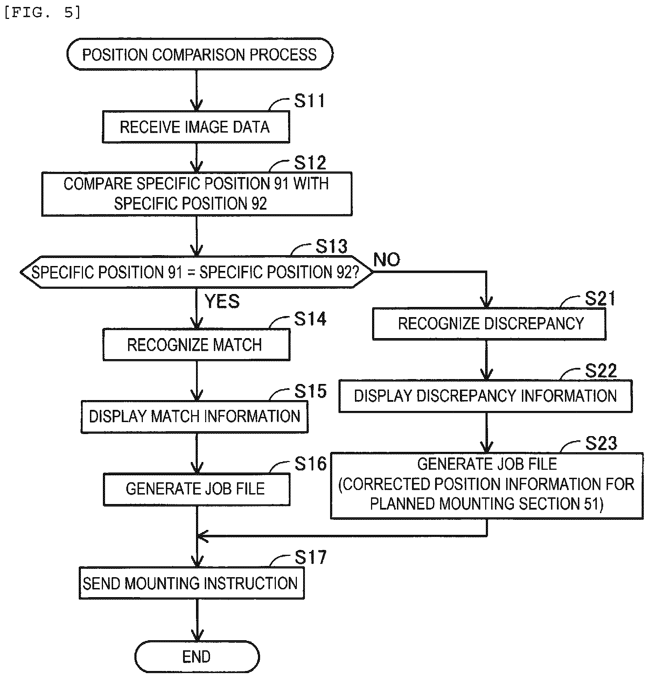

In mounting system 1, as shown in Fig. 5, a position comparison process is executed. In step S11 of the position comparison process, control device 30 receives the image data of surface 21 of circuit board 2 transmitted from camera 24. The image data includes an image of multiple planned mounting sections 51 and multiple planned electrode sections 52 on surface 21 of circuit board 2.

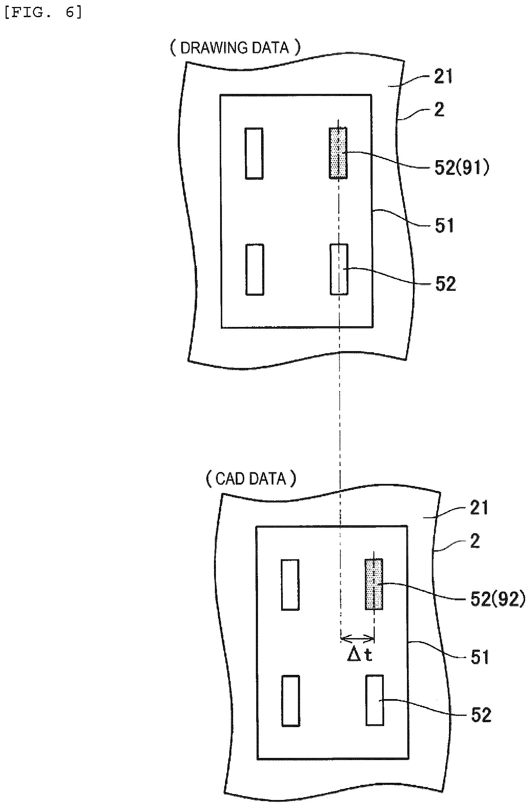

Next, in step S12, control device 30 compares specific position 91 in the received image data with specific position 92 in the CAD data stored in memory section 31. Specific position 91, 92 is, for example, the position of specific planned electrode section 52 among the multiple planned electrode sections 52 on surface 21 of circuit board 2. In the present embodiment, as shown in Fig. 6, the position of planned electrode section 52 shown colored in is defined as specific position 91, 92. Control device 30 compares the position information of specific position 91 in the image data (the upper side of the drawing) with the position information of specific position 92 in the CAD data (the lower side of the drawing).

Next, in step S13, control device 30 determines whether specific position 91 in the image data matches with specific position 92 in the CAD data. When the position information of specific position 91 and specific position 92 match with each other, control device 30 makes a YES determination in step S13 and the process proceeds to step S14. On the other hand, when the position information of specific position 91 and specific position 92 do not match with each other, control device 30 makes a NO determination and the process proceeds to step S21. In the example shown in Fig. 6, a positional deviation of Δt occurs on circuit board 2 between specific position 91 and specific position 92.

Next, in step S14, control device 30 recognizes that specific position 91 on circuit board 2 imaged by camera 24 matches with specific position 92 in the CAD data. As a result, control device 30 recognizes that multiple planned electrode sections 52 on surface 21 of circuit board 2 imaged by camera 24 are at the original predetermined positions. Further, control device 30 recognizes that multiple planned mounting sections 51 are at the original predetermined positions. That is, control device 30 recognizes that the actual positions of multiple planned mounting sections 51 and multiple planned electrode sections 52 on circuit board 2 match with the positions of multiple planned mounting sections 51 and multiple planned electrode sections 52 in the CAD data. Next, in step S15, control device 30 displays match information on operation panel 28. The match information is information indicating that there is no positional deviation between actual circuit board 2 and the CAD data.

Next, in step S16, control device 30 generates a job file. The job file includes, for example, information on mounting positions and mounting order of multiple electronic components 4. Control device 30 generates the job file based on the CAD data stored in memory section 31. Control device 30 acquires various pieces of position information from the CAD data and generates the job file.

On the other hand, in step S21 after the NO determination in step S13, control device 30 recognizes that specific position 91 on circuit board 2 imaged by camera 24 is different from specific position 92 in the CAD data. Thus, control device 30 recognizes that multiple planned electrode sections 52 on surface 21 of circuit board 2 imaged by camera 24 are not at the original predetermined positions. Further, control device 30 recognizes that multiple planned mounting sections 51 are not at the original predetermined positions. That is, control device 30 recognizes that the positions of multiple planned mounting sections 51 and multiple planned electrode sections 52 in actual circuit board 2 do not match with the positions of multiple planned mounting sections 51 and multiple planned electrode sections 52 in the CAD data. Next, in step S22, the control device 30 displays discrepancy information on operation panel 28. The discrepancy information is information indicating that a positional deviation has occurred between actual circuit board 2 and the CAD data. Control device 30 displays, for example, a warning on operation panel 28.

Next, in step S23, control device 30 generates a job file (an example of component mounting information). The job file is information used for mounting multiple electronic components 4 on surface 21 of circuit board 2. The job file includes, for example, information on mounting positions and mounting order of multiple electronic components 4. Control device 30 generates the job file based on the CAD data stored in memory section 31. Control device 30 acquires various pieces of position information from the CAD data and generates the job file. When generating the job file based on the CAD data, control device 30 generates the job file by correcting the position information indicating the positions of multiple planned mounting sections 51 and multiple planned electrode sections 52. Since a positional deviation occurs between actual circuit board 2 and the CAD data, control device 30 corrects the position information so as to compensate for the positional deviation.

In step S17 after steps S16 and S23, control device 30 transmits a mounting instruction to component mounting device 10 to mount multiple electronic components 4 on circuit board 2. Control device 30 transmits the mounting instruction based on the generated job file. Upon receiving the mounting instruction, component mounting device 10 mounts multiple electronic components 4 on circuit board 2. Component mounting device 10 mounts multiple electronic components 4 on circuit board 2 based on the job file.

Control device 30 executes each of the above-described processes for all of multiple component mounting devices 10. Each process executed by control device 30 is the same as each process described above, and therefore description thereof is omitted.

Mounting system 1 of the embodiment has been described above. As is apparent from the above description, mounting system 1 includes component mounting device 10, for mounting electronic component 4 on surface 21 of circuit board 2, and control device 30. Surface 21 of circuit board 2 is provided with planned mounting sections 51 on which mounting of electronic components 4 by component mounting device 10 is planned. Component mounting device 10 includes camera 24 for imaging surface 21 of circuit board 2. In addition, component mounting device 10 is configured to mount electronic components 4 on planned mounting sections 51 when planned mounting sections 51 of surface 21 of circuit board 2 are at predetermined positions. Control device 30 stores the CAD data in memory section 31, the CAD data depicting surface 21 of circuit board 2, on which electronic components 4 are mounted by component mounting device 10. Control device 30 compares specific position 92 in the CAD data stored in memory section 31 with specific position 91 in the image data of surface 21 of circuit board 2 imaged by camera 24 and recognizes that planned mounting section 51 of surface 21 of circuit board 2 is not at the predetermined position (see steps S12, S13, S21) if specific position 92 and specific position 91 do not match with each other.

Comparing the CAD data and the image data, the positions of planned mounting sections 51 in the CAD data and the positions of planned mounting sections 51 in the image data are supposed to be the same. However, due to some cause, the positions of planned mounting sections 51 in the CAD data and the positions of planned mounting sections 51 in the image data may deviate from each other. For example, before the step of mounting electronic components 4 on circuit board 2, a printing deviation may occur when wires are formed on surface 21 of circuit board 2 by printing, and thus planned mounting sections 51 may not be formed at the planned positions. In such a case, the positions of planned mounting sections 51 in the CAD data and the positions of planned mounting sections 51 in the image data are different from each other.

With the above configuration, by comparing specific position 92 in the CAD data with specific position 91 in the image data, it is possible to recognize whether a positional deviation has occurred between specific position 92 and specific position 91. When specific position 92 in the CAD data and specific position 91 in the image data are different from each other, control device 30 recognizes that planned mounting sections 51 on surface 21 of circuit board 2 are not at predetermined positions. As a result, it is possible to determine whether planned mounting sections 51 are at the original intended positions for mounting electronic components 4. That is, by comparing specific position 92 and specific position 91, it is possible to determine whether a positional deviation of planned mounting sections 51 has occurred. As a result, even if the operator using component mounting device 10 does not visually check actual circuit board 2, it is possible to determine whether planned mounting sections 51 are at the original intended positions. If planned mounting sections 51 are not at the original intended positions, electronic components 4 cannot be mounted at the correct positions. Otherwise, electronic components 4 can be mounted at the correct positions. As described above, it is possible to easily determine whether electronic components 4 can be mounted at the correct positions.

Although one embodiment has been described above, specific embodiments are not limited to the embodiment described above. In the following description, the same components as those in the above description are denoted by the same reference numerals, and description thereof is omitted.

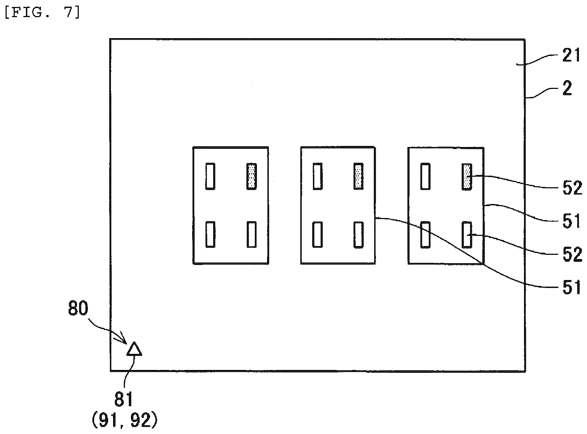

In the above-described embodiment, the position of specific planned electrode section 52 among multiple planned electrode sections 52 is defined as specific position 91, 92, but the present invention is not limited to this configuration. Specific position 91, 92 can be changed as appropriate. For example, the position of the edge of planned mounting section 51 of surface 21 of circuit board 2 may be defined as specific position 91, 92. Alternatively, as shown in Fig. 7, the position of mark 81 of a polygon (e.g., a triangle) displayed at corner 80 of surface 21 of circuit board 2 may be defined as specific position 91, 92. Mark 81 is printed on surface 21 of circuit board 2. Corner 80 is a part that is surrounded by two edges of circuit board 2.

While specific examples of the present invention have been described in detail above, these are illustrative only and are not intended to limit the scope of the claims.

### Reference Signs List

1: Mounting system
2: Circuit board
4: Electronic component
6: Suction nozzle
10: Component mounting device
12: Component feeder
14: Feeder holding section
16: Mounting head
18: Moving mechanism
18a: Movement base
20: Imaging unit
21: Surface
22: Camera support
24: Camera
26: Conveyance device
28: Operation panel
30: Control device
31: Memory section
32: Supporting device
34: Support pin
38: Support table
41: Electrode
51: Planned mounting section
52: Planned electrode section
80: Corner
81: Mark
91: Specific position
92: Specific position

## Claims

1. A mounting system (1) comprising a component mounting device (10) configured to mount multiple components (4) on a surface (21) of a board (2), and a control device (30),
wherein multiple planned mounting sections (51), at which mounting of multiple components (4) by the component mounting device (10) is planned, and multiple planned electrode sections (52) are composed of multiple wires printed on the surface (21) of the board (2);
wherein the component mounting device (10) comprises an imaging device (24), being configured to image the surface (21) of the board (2), and is configured to mount the multiple components (4) on the multiple planned mounting sections (51) when the multiple planned mounting sections (51) of the board surface (21) are at predetermined positions, and
wherein the control device (30) is configured to store drawing information depicting the board surface (21) on which the multiple components (4) are to be mounted by the component mounting device (10), and to compare a specific position (92) in the stored drawing information with a specific position (91) in image information of the board surface (21) imaged by the imaging device (24), wherein the specific position (91, 92) is a position of a specific planned electrode section (52), a position of an edge of one of the multiple planned mounting sections (51) or a position of polygonal mark (81) displayed on a corner (80) of the surface (21) of the circuit board (2),
**characterized in that**
the control device (30) is further configured to recognize that the multiple planned mounting sections (51) of the board surface (21) are not at the predetermined positions when the position information of the specific position (92) in the drawing information and the specific position (91) in the image information do not match with each other, causing a positional deviation (Δt) on the circuit board between the specific position (91) in the image information and the specific position (92) in the drawing information, and
wherein the control device (30) is capable of generating component mounting information to be used for mounting the multiple components (4) on the board surface (21) based on the stored drawing information, and, is configured to correct the position information indicating the positions of the multiple planned mounting sections (51) for mounting the multiple components (4) to generate the component mounting information when the multiple planned mounting sections (51) of the board surface (21) are not present at the predetermined positions, so as to compensate for the positional deviation (Δt).

2. The mounting system (1) of claim 1,
wherein multiple component mounting devices (10) are provided; and
wherein the control device (30) is configured to store, for each of the multiple component mounting devices (10), drawing information depicting the corresponding board surface (21) at which multiple components (4) are mounted by the component mounting device (10); and to compare a stored specific position (92) in the drawing information with a specific position (91) in the image information of the corresponding board surface (21) imaged by the imaging device (24), and to recognize that the multiple planned mounting sections (51) of the corresponding board surface (21) are not at the predetermined positions when the specific position (92) in the drawing information and the position information of the specific position (91) in the image information do not match with each other.

## Patentansprüche

1. Montagesystem (1), mit einer Komponentenmontagevorrichtung (10), die zur Montage mehrerer Komponenten (4) auf einer Oberfläche (21) einer Platine (2) konfiguriert ist, und einer Steuervorrichtung (30),
wobei mehrere geplante Montageabschnitte (51), an denen die Montage mehrerer Komponenten (4) durch die Komponentenmontagevorrichtung (10) geplant ist, und mehrere geplante Elektrodenabschnitte (52) aus mehreren auf der Oberfläche (21) der Platine (2) gedruckten Drähten bestehen;
wobei die Komponentenmontagevorrichtung (10) eine Bildgebungsvorrichtung (24) umfasst, die dazu konfiguriert ist, die Oberfläche (21) der Platine (2) abzubilden, und dazu konfiguriert ist, die mehreren Komponenten (4) auf den mehreren geplanten Montageabschnitten (51) zu montieren, wenn sich die mehreren geplanten Montageabschnitte (51) der Platinenoberfläche (21) an vorbestimmten Positionen befinden, und
wobei die Steuervorrichtung (30) dazu konfiguriert ist, Zeichnungsinformationen zu speichern, die die Platinenoberfläche (21) darstellen, auf der die mehreren Komponenten (4) durch die Komponentenmontagevorrichtung (10) montiert werden sollen, und eine bestimmte Position (92) in den gespeicherten Zeichnungsinformationen mit einer bestimmten Position (91) in Bildinformationen der vom Bildgebungsvorrichtung (24) abgebildeten Platinenoberfläche (21) zu vergleichen, wobei die bestimmte Position (91, 92) eine Position eines bestimmten geplanten Elektrodenabschnitts (52), eine Position einer Kante eines der mehreren geplanten Montageabschnitte (51), oder eine Position einer polygonalen Markierung (81) ist, die an einer Ecke (80) der Oberfläche (21) der Platine (2) angezeigt wird,
**dadurch gekennzeichnet, dass**
die Steuereinrichtung (30) weiterhin so konfiguriert ist, dass sie erkennt, dass sich die mehreren geplanten Montageabschnitte (51) der Platinenoberfläche (21) nicht an den vorgegebenen Positionen befinden, wenn die Positionsinformationen der bestimmten Position (92) in den Zeichnungsinformationen und die bestimmte Position (91) in den Bildinformationen nicht miteinander übereinstimmen, was zu einer Positionsabweichung (Δt) auf der Platine (2) zwischen der bestimmten Position (91) in den Bildinformationen und der bestimmten Position (92) in den Zeichnungsinformationen führt, und
wobei die Steuervorrichtung (30) im Stande ist, basierend auf den gespeicherten Zeichnungsinformationen Komponentenmontageinformationen zu erzeugen, die zur Montage der mehreren Komponenten (4) auf der Platinenoberfläche (21) verwendet werden sollen, und konfiguriert ist, um die Positionsinformationen zu korrigieren, die die Positionen der mehreren geplanten Montageabschnitte (51) zur Montage der mehreren Komponenten (4) anzeigen, um die Komponentenmontageinformationen zu generieren, wenn die mehreren geplanten Montageabschnitte (51) der Platinenoberfläche (21) nicht an den vorbestimmten Positionen vorhanden sind, um so die Positionsabweichung (Δt) zu kompensieren.

2. Montagesystem (1) nach Anspruch 1,
wobei mehrere Komponentenmontagevorrichtungen (10) vorgesehen sind; und
wobei die Steuervorrichtung (30) so konfiguriert ist, dass sie für jede der mehreren Komponentenmontagevorrichtungen (10) Zeichnungsinformationen speichert, die die entsprechende Platinenoberfläche (21) darstellen, an der mehrere Komponenten (4) durch die Komponentenmontagevorrichtung (10) montiert werden; und
eine gespeicherte bestimmte Position (92) in den Zeichnungsinformationen mit einer bestimmten Position (91) in den Bildinformationen der entsprechenden durch die Bildgebungsvorrichtung (24) abgebildeten Platinenoberfläche (21) vergleicht, und erkennt, dass die mehreren geplanten Montageabschnitte der entsprechenden Platinenoberfläche (21) sich nicht an den vorgegebenen Positionen befinden, wenn die bestimmte Position (92) in den Zeichnungsinformationen und die Positionsinformationen der bestimmten Position (91) in den Bildinformationen nicht miteinander übereinstimmen.

## Revendications

1. Système de montage (1) comprenant un dispositif de montage de composants (10) configuré pour monter de multiples composants (4) sur une surface (21) d'une carte (2), et un dispositif de commande (30),
dans lequel de multiples sections de montage planifié (51), au niveau desquelles le montage de multiples composants (4) par le dispositif de montage de composants (10) est planifié, et de multiples sections d'électrode planifiée (52) sont composées de multiples fils imprimés sur la surface (21) de la carte (2) ;
dans lequel le dispositif de montage de composants (10) comprend un dispositif d'imagerie (24), qui est configuré pour imager la surface (21) de la carte (2), et est configuré pour monter les multiples composants (4) sur les multiples sections de montage planifié (51) lorsque les multiples sections de montage planifié (51) de la surface de carte (21) se trouvent à des positions prédéterminées, et
dans lequel le dispositif de commande (30) est configuré pour stocker des informations de dessin représentant la surface de carte (21) sur laquelle les multiples composants (4) doivent être montés par le dispositif de montage de composants (10), et pour comparer une position spécifique (92) dans les informations de dessin stockées à une position spécifique (91) dans les informations d'image de la surface de carte (21) imagée par le dispositif d'imagerie (24), où la position spécifique (91, 92) est une position d'une section d'électrode planifiée spécifique (52), une position d'un bord de l'une des multiples sections de montage planifié (51) ou une position d'une marque polygonale (81) affichée sur un coin (80) de la surface (21) de la carte de circuit imprimé (2),
**caractérisé en ce que**
le dispositif de commande (30) est en outre configuré pour reconnaître que les multiples sections de montage planifié (51) de la surface de carte (21) ne se trouvent pas aux positions prédéterminées lorsque les informations de position de la position spécifique (92) dans les informations de dessin et la position spécifique (91) dans les informations d'image ne correspondent pas, provoquant un écart de position (Δt) sur la carte de circuit imprimé entre la position spécifique (91) dans les informations d'image et la position spécifique (92) dans les informations de dessin, et
dans lequel le dispositif de commande (30) est capable de générer des informations de montage de composants à utiliser pour monter les multiples composants (4) sur la surface de carte (21) sur la base des informations de dessin stockées, et est configuré pour corriger les informations de position indiquant les positions des multiples sections de montage planifié (51) pour monter les multiples composants (4) afin de générer les informations de montage de composants lorsque les multiples sections de montage planifié (51) de la surface de carte (21) ne sont pas présentes aux positions prédéterminées, de manière à compenser l'écart de position (Δt).

2. Système de montage (1) de la revendication 1,
dans lequel de multiples dispositifs de montage de composants (10) sont prévus ; et
dans lequel le dispositif de commande (30) est configuré pour stocker, pour chacun des multiples dispositifs de montage de composants (10), des informations de dessin décrivant la surface de carte correspondante (21) sur laquelle de multiples composants (4) sont montés par le dispositif de montage de composants (10) ; et pour comparer une position spécifique stockée (92) dans les informations de dessin à une position spécifique (91) dans les informations d'image de la surface de carte correspondante (21) imagée par le dispositif d'imagerie (24), et pour reconnaître que les multiples sections de montage planifié (51) de la surface de carte correspondante (21) ne se trouvent pas aux positions prédéterminées lorsque la position spécifique (92) dans les informations de dessin et les informations de position de la position spécifique (91) dans les informations d'image ne correspondent pas.
